# EUROPEAN PATENT SPECIFICATION

(11) **EP 0 483 107 B1**
(45) Date of publication and mention of the grant of the patent: **20.01.1999**
(21) Application number: 92100516.1
(22) Date of filing: 03.10.1986
(51) Int. Cl.: H05K 7/20, H01L 23/46, H01L 23/473

(54) **Cooling modules for electronic circuit devices**
Kühlmodule für Vorrichtungen mit elektronischem Schaltkreis
Modules de refroidissement pour dispositifs de circuit électronique

(30) Priority: 28.01.1986 JP 17031/86
(43) Date of publication of application: 29.04.1992
(62) Divisional of application: 86307669.1
(73) Proprietor: FUJITSU LIMITED, Kawasaki-shi, Kanagawa 211 (JP)
(72) Inventor: Yamamoto, Haruhiko, Yokohama-shi, Kanagawa 222 (JP); Suzuki, Masahiro, Inagi-shi, Tokyo 206 (JP); Nakata, Mitsuhiko, Kawasaki-shi, Kanagawa 214 (JP); Katsuyama, Koji, Yokohama-shi, Kanagawa 241 (JP)
(74) Representative: Fane, Christopher Robin King

(56) References cited:
- EP-A- 0 151 068

## Description

The present invention relates to cooling modules for electronic circuit devices.

A printed circuit board holding electronic circuit components, such as semiconductors, large scale integrated circuits (LSI's), or integrated circuit (IC's) may be cooled by a series of cooling modules which are operable to remove the heat dissipated from the components.

In U.S. Patent No. 4,233,645 there is disclosed a cooling module, in combination with an electronic circuit component mounted on a printed circuit board, including a heat transfer body, for conducting heat from the electronic circuit component, resilient biasing means connected to the heat transfer body and serving to urge that body towards the electronic circuit component, and guide means for guiding the heat transfer body towards the electronic circuit component.

It is desirable to provide an improved form of cooling module.

According to the present invention there is provided a cooling module, in combination with an electronic circuit component mounted on a printed circuit board, including a heat transfer surface, for conducting heat from the electronic circuit component, resilient biasing means connected to the heat transfer surface and serving to urge that surface towards the electronic circuit component, and guide means for guiding the heat transfer surface towards the electronic circuit component, **characterised in that** the guide means comprises a plurality of either (a) guide rods which extend within respective recesses formed in the peripheral region of the heat transfer surface or (b) guide plates that are curved to partially surround the periphery of the heat transfer surface, spaced apart laterally around a peripheral region of the heat transfer surface and extending longitudinally in the direction from that surface towards the electronic circuit component.

The heat transfer surface is preferably larger in diameter than the biasing means. In one embodiment, the heat transfer surface comprises a heat transfer plate. The heat transfer surface may further comprise a substantially cylindrical tubular body, which is larger in diameter than the biasing means, one end of the tubular body being closed by the plate.

Reference will now be made, by way of example, to the accompanying drawings, in which:
Fig. 1 is a schematic axial sectional view of a first electronic circuit device not embodying the present invention;
Fig. 2 is a schematic sectional view of an assembly of devices similar to Fig. 1;
Fig. 3 is a perspective view of the assembly shown in Fig. 2;
Fig. 4 is an axial sectional view of an electronic circuit device embodying the present invention;
Fig. 5 is an axial sectional view of another electronic circuit device embodying the present invention;
Fig. 6 is a schematic plan view of part of either of the devices shown in Figs. 4 and 5;
Fig. 7 is a view similar to Fig. 6, but showing a variant thereof;

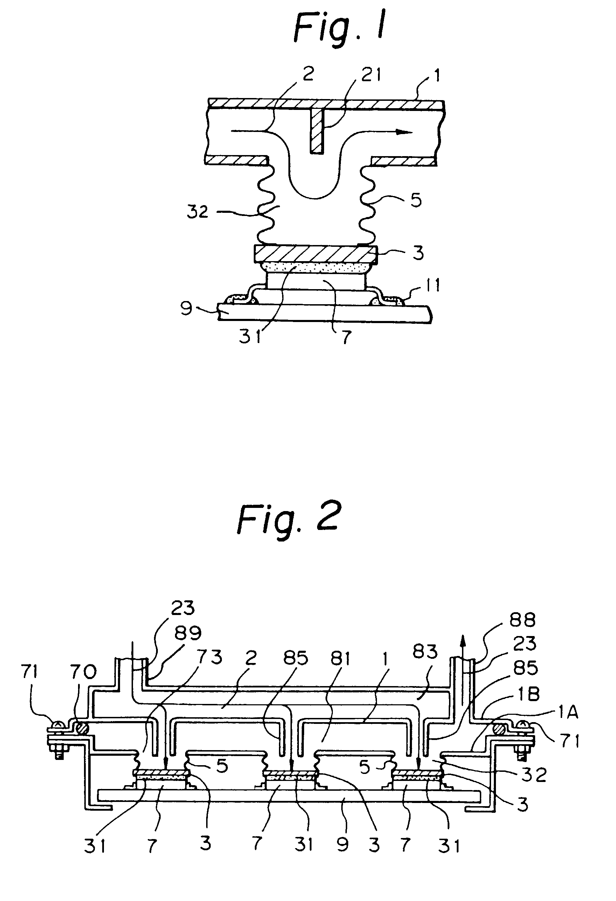

Figure 1 shows an electronic circuit device, not embodying the present invention, including a cooling module having a passage 1 for coolant flow.

The coolant can be gas but it is not limited thereto, or may be a liquid, such as water, liquid fluorocarbon, or even a liquid metal such as mercury or gallium. The passage 1 may be a part of a recirculation line having a pump and a heat radiator or heat exchanger.

A heat transfer plate 3 which is made of, for example, a heat conductive material such as copper or brass, is connected to the passage 1 by means of a bellows 5 attached to the passage 1. The heat transfer plate 3 may be made of a metal having a high solder wetting property. The bellows 5 may be made of a thin sheet of copper or stainless steel. The passage 1 has a deflector 21 extending towards the heat transfer plate 3. A coolant circulation zone 32 is defined in the bellows 5, in which zone 32 the heat transfer plate 3 is exposed to the coolant at one side of the plate 3.

The direction of the coolant flow in the passage 1 is changed by the deflector 21, and heat is removed from the heat transfer plate 3 in the circulation zone 32.

The plate 3 is urged resiliently towards an electronic circuit component 7, such as a semiconductor IC or LSI, provided on a printed circuit board 9, by means of the bellows 5 and the hydraulic pressure of the coolant.

The component 7 is bonded to the printed circuit board 9 by, for example, solder 11.

In the device of Figure 1, an intermediate layer of solder 31 is provided between the heat transfer plate 3 and the circuit component 7. The intermediate layer 31 is secured to the bottom face of the heat transfer plate 3. Alternatively, the intermediate layer 31 can be secured to the circuit component 7 on the printed circuit board 9.

The solder 31 maintains its original sheet-like shape at a normal temperature, i.e. when the circuit device is not in operation. When the circuit device is operated, and consequently produces heat, the solder 31 is melted so that the heat transfer plate 3 and the circuit component 7 are joined by the solder 31. Thus, the plate 3 and component 7 can be connected to each other in a substantially complete face-to-face fashion, regardless of any unevenness of the contacting surfaces thereof.

Thus, cooling efficiency of the cooling module can be high, because the second solder 31 ensures a thermal connection between the heat transfer plate 3 and the circuit component 7.

Figure 2 shows an assembly of cooling modules similar in principle to that of Figure 1, in which the passage 1 comprises a lower half 1A and an upper half 1B. The lower half 1A has, for example, a generally U-shaped cross section, and has openings 73 connected to the recirculation zones 32 of the cooling modules. The upper half 1B can be fitted onto the lower half 1A to define an outlet passage 81.

The upper half 1B, therefore, acts as a cover of the passageway for the coolant 2. The upper half 1B has an upper inlet passage 83 which corresponds to the passage 1 in Fig. 1. The passage 83 is connected to the outlet passage 81 by nozzles 85, so that the coolant 2 fed through a recirculation line is fed or ejected towards the respective opposing main faces of the heat transfer plates 3 of the cooling modules through the nozzles 85, and is returned to the recirculation line through the outlet passage 81 and an outlet pipe 88 provided on the upper half 1B of the passage 1. The coolant 2 can be introduced into the inlet passage 83 from an inlet pipe 89 provided on the upper half 1B.

The upper half 1B can be detachably connected to the lower half by, for example, bolts 71.

The numeral 70 designates a seal, such as a ring packing or a gasket, which is located between the upper and lower halves 1A and 1B to seal the connection therebetween.

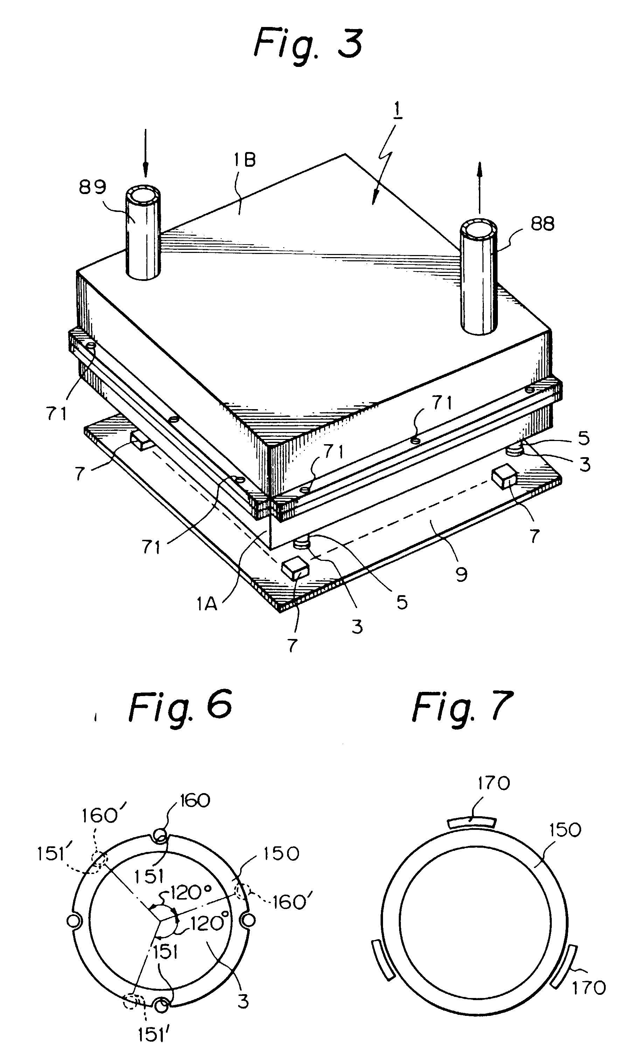

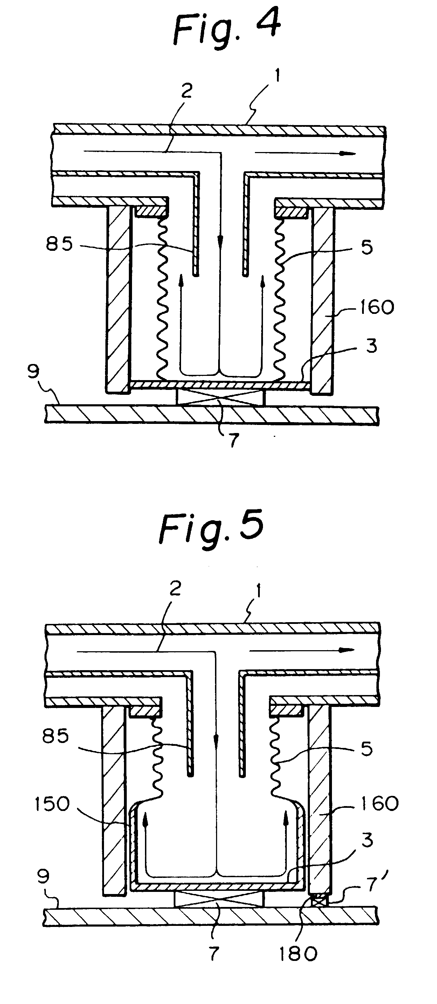

Figure 3 shows one example of a perspective appearance of a cooling unit having an assembly of cooling modules such as are shown in Fig. 2. In Fig. 3, the inlet pipe 89 and the outlet pipe 88 are in different positions from those shown in Fig. 2. The cover 1B can be detached from the lower half 1A by removing the bolts 71.

Figure 4 shows a cooling module, similar in some respects to the module of Fig. 1, in an embodiment of the present invention. In Fig. 4, bellows 5 is directly connected to heat transfer plate 3, which is larger in diameter than the bellows. The peripheral edge of the plate 3 is guided, in the direction towards the component 7, by guide rods 160 which will be described hereinafter.

Figure 5 shows a different embodiment, in which a substantially cylindrical tubular body 150 is connected at an open upper end thereof to the bottom end of the bellows 5, which is smaller in diameter than the tubular body 150, and is closed at its lower end by plate 3. The tubular body 150 has a larger surface area than the heat transfer plate 3 in Fig. 4.

Fig. 6 shows a preferred arrangement of the guide rods 160 around the plate 3 (Fig. 4) or the tubular body 150 (Fig. 5). Such guide rods serve to prevent the plate 3 from being inclined with respect to the plane of the component 7. As can be appreciated from Fig. 6 the guide rods 160, which extend vertically downward from the passage 1, extend within recesses 151 provided at the periphery of the plate 3 (Fig. 4) or at the outer surface of the tubular body 150 (Fig. 5). The guide rods 160 also contribute to prevention of undesirable and accidental movement of the plate 3 during operation of the cooling modules.

The guide rods 160 can be replaced by elongate guide plates 170 which extend alongside the tubular body 150 and are curved so as to have an arcuate cross-section that partially surrounds the tubular body 150 as shown in Fig. 7. In this alternative, the recesses 151 shown in Fig. 6 can be omitted.

Because the diameter of the plate 3 or tubular body 150 is larger than that of the bellows 5, the latter, which has usually a very small thickness, is prevented from coming into undesirable contact or collision with the guide rods 160 or plates 170.

The number of guide members is not limited to four; only three rods 160' may be sufficient, as shown by broken lines in Fig. 6. For the three guide rods 160', three recesses 151' can be provided at a 120° spacing. More than four guide rods can be also provided.

As shown in Fig. 5, it is possible to locate a small circuit component or components 7', different from the component 7, below one or more of the guide rods 160, 160' or plates 170, so that the small component(s) 7' can be also cooled at the same time. A compound or compounds 180 having a high heat conductivity can be inserted between the lower end(s) of the guide rod(s) 160 or plate(s) 170 and the corresponding component(s) 7'. The compound(s) 180 can serve as spacer means for adjusting the distance between the lower end(s) of the guide rod(s) 160 or plate(s) 170 and the component(s) 7'. In this alternative, the guide rod(s) 160 or plate(s) 170 should be made of a material having high heat conductivity, such as copper.

The cooling apparatus can be used upside down, so that the coolant is ejected upward from the nozzles 85 towards the heat transfer plates 3 located above the nozzles 85.

## Claims

1. A cooling module, in combination with an electronic circuit component (7) mounted on a printed circuit board (9), including a heat transfer surface (3), for conducting heat from the electronic circuit component (7), resilient biasing means (5) connected to the heat transfer surface (3) and serving to urge that surface (3) towards the electronic circuit component (7), and guide means (160; 160'; 170) for guiding the heat transfer surface (3) towards the electronic circuit component (7), **characterised in that** the guide means (160; 160'; 170) comprises a plurality of either (a) guide rods (160; 160') which extend within respective recesses (151; 151') formed in the peripheral region of the heat transfer surface (3) or (b) guide plates (170) that are curved to partially surround the periphery of the heat transfer surface (3), spaced apart laterally around a peripheral region of the heat transfer surface (3) and extending longitudinally in the direction from that surface (3) towards the electronic circuit component (7).

2. A cooling module as claimed in claim 1, wherein the heat transfer surface (3) is larger in diameter than the biasing means (5).

3. A device as claimed in claim 1 or claim 2, wherein the heat transfer surface comprises a heat transfer plate (3).

4. A device as claimed in claim 3, wherein the heat transfer surface further comprises a cylindrical tubular body (150), which is larger in diameter than the biasing means (5), one end of the tubular body (150) being closed by the plate (3).

## Patentansprüche

1. Kühlmodul in Kombination mit einer elektronischen Schaltungskomponente (7), die auf einer gedruckten Schaltungsplatte (9) montiert ist, mit einer Wärmeübertragungsfläche (3), um Wärme von der elektronischen Schaltungskomponente (7) abzuleiten, mit einer nachgiebigen Vorspanneinrichtung (5), die mit der Wärmeübertragungsfläche (3) verbunden ist und dazu dient, um diese Fläche (3) zu der elektronischen Schaltungskomponente (7) zu drücken, und mit einer Führungseinrichtung (160; 160'; 170) zum Führen der Wärmeübertragungsfläche (3) zu der elektronischen Schaltungskomponente (7) hin, dadurch **gekennzeichnet**, daß die Führungseinrichtung (160; 160'; 170) eine Vielzahl von entweder (a) Führungsstangen (160: 160') aufweist, die sich innerhalb jeweiliger Ausnehmungen (151, 151') erstrecken, die in der peripheren Zone der Wärmeübertragungsfläche (3) ausgebildet sind, oder (b) Führungsplatten (170) aufweist, die gekrümmt sind, so daß sie teilweise die Peripherie der Wärmeübertragungsfläche (3) umschließen und die seitlich um eine periphere Zone der Wärmeübertragungsfläche (3) beabstandet sind und sich longitudinal in der Richtung von dieser Fläche (3) zu der elektronischen Schaltungskomponente (7) hin erstrecken.

2. Kühlmodul nach Anspruch 1, bei dem die Wärmeübertragungsfläche (3) im Durchmesser größer ist als die Vorspanneinrichtung (5).

3. Vorrichtung nach Anspruch 1 oder nach Anspruch 2, bei der die Wärmeübertragungsfläche eine Wärmeübertragungsplatte (3) aufweist.

4. Vorrichtung nach Anspruch 3, bei der die Wärmeübertragungsfläche ferner einen zylindrischen Rohrkörper (150) aufweist, der im Durchmesser größer ist als die Vorspanneinrichtung (5), wobei ein Ende des Rohrkörpers (150) durch die Platte (3) verschlossen ist.

## Revendications

1. Module de refroidissement, combiné à un composant électronique (7) de circuit, monté sur une carte (9) de circuit imprimé, comportant une surface (3) de transfert de chaleur destinée à conduire de la chaleur du composant électronique (7), un dispositif élastique de rappel (5) raccordé à la surface (3) de transfert de chaleur et utilisé pour rappeler cette surface (3) vers le composant électronique (7) du circuit, et un dispositif (160 ; 160' ; 170) de guidage de la surface de transfert de chaleur (3) vers le composant électronique (7) , caractérisé en ce que le dispositif de guidage (160 ;160', 170) comporte plusieurs éléments choisis parmi (a) des tiges de guidage (160 ;160') qui s'étendent dans des cavités respectives (151, 151') formées dans la région périphérique de la surface (3) de transfert de chaleur, et (b) des plaques de guidage (170) qui sont courbées pour entourer partiellement la périphérie de la surface (3) de transfert de chaleur et qui sont espacées latéralement autour d'une région périphérique de la surface (3) de transfert de chaleur et s'étendent longitudinalement dans la direction allant de cette surface (3) vers le composant électronique (7).

2. Module de refroidissement selon la revendication 1, dans lequel la surface (3) de transfert de chaleur a un diamètre supérieur à celui du dispositif de rappel (5).

3. Dispositif selon la revendication 1 ou 2, dans lequel la surface de transfert de chaleur est une plaque (3) de transfert de chaleur.

4. Dispositif selon la revendication 3, dans lequel la surface de transfert de chaleur comporte en outre un corps tubulaire cylindrique (150) de diamètre supérieur à celui du dispositif de rappel (5), une extrémité du corps tubulaire (150) étant fermée par la plaque (3).
